# EUROPEAN PATENT APPLICATION

(11) **EP 1 263 002 A2**
(43) Date of publication of application: **04.12.2002**
(21) Application number: 02253404.4
(22) Date of filing: 15.05.2002
(51) Int. Cl.: H01C 7/18, H05K 1/16

(54) **Resistors**

(30) Priority: 17.05.2001 US 291588 P
(71) Applicant: Shipley Company LLC, Marlborough, MA 01752 (US)
(72) Inventor: Schemenaur, John, Scottsdale AZ 85267 (US); Senk, David D., Mission Viejo, California 92692 (US)
(74) Representative: Kent, Venetia Katherine

(57) **Abstract**

Resistive materials having resistivities that are axis dependent are provided. Such resistive materials having a resistivity in a first direction and a very different resistivity in an orthogonal direction. These resistive materials are particularly suitable for use as resistors embedded in printed wiring boards.

## Description

### Background of the invention

The present invention relates generally to the field of resistive materials. In particular, the present invention relates to the field of resistive materials suitable for use as embedded resistors in electronic devices.

Printed circuit boards typically include large numbers of electronic devices which are commonly surface mounted and also additional components which may be present in the form of active layers within each printed circuit board. The requirements for the devices and components in such printed circuit boards are subject to conventional electronic design restraints. In particular, many of the surface mounted devices and other components on such printed circuit boards commonly require coupling with individual resistors in order to achieve their desired function.

The most common solution to this problem in the prior art has been the use of individual resistors as additional surface mounted components on the printed circuit boards. Design of the printed circuit boards has further required the provision of through-holes in order to properly interconnect the resistors. In this regard, the resistors may be interconnected between any combination of surface devices or components or active components or layers formed on or within the printed circuit boards.

As a result, the complexity of the printed circuit boards has increased and at the same time the available surface area of the printed circuit boards for other devices has decreased or else the overall size of the printed circuit boards has increased to accommodate necessary surface devices and components including resistors.

One solution to this has been the use of planar resistors preferably formed on internal layers of the printed circuit boards in order to replace surface mounted resistors as described above while making surface portions of the printed circuit boards free for other uses. For example, U.S. Patent No. 4,808,967 (Rice et al.) discloses a printed wiring board having a support layer, a layer of electrical resistance material adhering to the support layer, and a conductive layer adhering to the electrical resistance layer.

A problem with certain conventional planar resistors is that the resistance measured in a first direction may differ slightly from the resistance measured in a second direction orthogonal to the first direction. If care is not taken in the manufacture of an electronic device, such as a printed wiring board, such planar resistors may be used in the wrong orientation. In such cases, the actual resistivity of may differ from that desired, thus adversely affecting the performance of the printed wiring board.

One of the objections to adopting embedded resistor technology in printed wiring board manufacture is that such resistor technology is limited in the range of values that it can provide. Unless large serpentine patterns are employed, a single layer of embedded resistor material is limited to about three decades of values, such as, for example, from 50 ohms to 5,000 ohms. In order to accommodate values above this range one must place discrete resistors on the surface of the printed wiring board, which negates some of the gain from embedding the resistor within the board, or alternatively, use a second sheet of higher resistivity material, which carries a higher cost of materials penalty.

There is thus a need for a resistive material having a resistivity that is dependent on the orientation of the embedded resistor.

### Summary of the Invention

It has been surprisingly found that the sheet resistivity of a material may be significantly changed by structuring such material. Such structured resistivity material has very different sheet resistivitics in orthogonal directions, thus increasing the likelihood of the correct orientation of the resistive material during electrode formation to form a resistor.

In one aspect, the present invention provides a resistor having a resistive material and a pair of electrodes disposed at opposite ends of the resistive material, the resistive material having a plurality of structures disposed substantially parallel to the pair of electrodes.

In another aspect, the present invention provides a resistor having a resistive material and a pair of electrodes disposed at opposite ends of the resistive material, the resistive material having a plurality of structures disposed substantially orthogonal to the pair of electrodes.

In still another aspect, the present invention provides a resistive material having a first resistivity in a first direction and a second resistivity in a second direction, wherein the second direction is substantially orthogonal to the first direction and wherein the first resistivity is greater than or equal to 2 times the second resistivity.

In yet another aspect, the present invention provides a resistive material having a first resistive material layer and structures disposed on the first resistive material layer, the structures including a second resistive material, wherein the resistive material has a first resistivity in a first direction and a second resistivity in a second direction, wherein the second direction is substantially orthogonal to the first direction.

In a further aspect, the present invention provides a printed wiring board including a resistor, the resistor including a pair of electrodes and a resistive material having a first resistive material layer and a structures disposed on the first resistive material layer, the structures including a second resistive material, wherein the resistive material has a first resistivity in a first direction and a second resistivity in a second direction, wherein the second direction is substantially orthogonal to the first direction. Preferably, such structures are disposed substantially parallel to or substantially orthogonal to the pair of electrodes.

In a still further aspect, the present invention provides an electronic device including a resistor as described above. Also provided by the present invention is an electronic device including a printed wiring board as described above.

In yet another aspect, the present invention provides a method of changing the resistivity of a resistive material layer comprising the step of structuring the resistive material in the direction of or orthogonal to the direction of resistivity.

### Brief Description of the Drawing

Fig. 1 illustrates a resistor having ribs that are parallel to the direction of resistivity.

Fig. 2 illustrates a resistor having ribs that are orthogonal to the direction of resistivity.

Fig. 3 illustrates a resistive material having discontinuous ribs that are parallel to the direction of resistivity.

### Detailed Description of the Invention

As used throughout this specification, the following abbreviations shall have the following meanings, unless the context clearly indicates otherwise: °C = degrees centigrade; °F = degrees Fahrenheit; nm = nanometer; µm = micron = micrometer; Å = angstrom; Ω = Ohms; Ω/□ = Ohms per square; M = molar; wt % = percent by weight; and mil = 0.001 inch.

The terms "printed wiring board" and "printed circuit board" are used interchangeably throughout this specification. By "substantially orthogonal" it is meant directions that are substantially at right angles to each other, i.e. 90° ± 15°, preferably 90° ± 10°, more preferably 90° ± 5° and still more preferably 90° ± 3°. Unless otherwise noted, all amounts are percent by weight and all ratios are by weight. All numerical ranges are inclusive and combinable in any order, except where it is obvious that such numerical ranges are constrained to add up to 100%.

The present invention provides a resistive material having a first resistivity in a first direction and a second resistivity in a second direction, wherein the second direction is substantially orthogonal to the first direction and wherein the first resistivity is greater than or equal to 2 times the second resistivity. The resistivity of the present resistive materials is axis dependent. Thus, the present materials have a first resistivity in the X-direction and a very different resistivity in the Y-direction i.e., in a direction substantially at right angles to the first (or X) direction. Such differences in resistivity are achieved by structuring the resistive material, The term "structure" refers to ribs, stripes, lines, rods, rows and the like of a second material disposed on a first or base material. Accordingly, the present invention also provides a resistive material having a first resistive material layer and structures disposed on the first resistive material layer, the structures including a second resistive material, wherein the resistive material has a first resistivity in a first direction and a second resistivity in a second direction, wherein the second direction is substantially orthogonal to the first direction.

The first or base material is a resistive material. A wide variety of resistive materials arc suitable for use as the first material. Suitable resistive materials include, but are not limited to, a mixture of a conductive material and a minor amount of a highly resistive (dielectric) material. A very small amount of the highly resistive material, e.g., about 0.1 wt % to about 20 wt %, very profoundly reduces the conductive properties of the conducting material. Although noble metals are conductors, it is found that in depositing noble metals along with relatively minor amounts of oxides, such as silica or alumina, the deposited material becomes highly resistive. Accordingly, metals, such as platinum, containing minor amounts, e.g., 0,1%-5% of an oxide, can serve as resistors in printed circuit boards. For example, platinum, though an excellent conductor, when co-deposited with between 0.1 and about 5 wt % silica, serves as a resistor, the resistance being a function of the level of silica co-deposited. Any conductive material is suitable, such as, but not limited to, platinum, iridium, ruthenium, nickel, copper, silver, gold, indium, tin, iron, molybdenum, cobalt, lead, palladium, and the like. Suitable dielectrics include, but are not limited to, metal oxides or metalloid oxides, such as silica, alumina, chromia, titania, ceria, zinc oxide, zirconia, phosphorous oxide, bismuth oxide, oxides of rare earth metals in general, phosphorus, and mixtures thereof.

Preferred electrically resistive materials for use as the first material are nickel-based or platinum-based, i.e., the major material is nickel or platinum, respectively. Suitable preferred resistive materials are nickel-phosphorus, nickel-chromium, nickel-phosphorus-tungsten, ceramics, conductive polymers, conductive inks, platinum-based materials such as platinum-iridium, platinum-ruthenium and platinum-iridium-ruthenium. Preferred platinum-based materials contain from about 10 to 70 mole percent iridium, ruthenium or mixtures thereof, and preferably 2 mole percent to 50 mole percent, calculated relative to platinum being 100 percent. If ruthenium is used alone (without iridium), it is preferably used at between about 2 and about 10 mole percent calculated relative to platinum being 100 percent. If iridium is used alone (without ruthenium), it is preferably used at between about 20 and about 70 mole percent calculated relative to platinum being 100 percent. In the resistive materials in accordance with the invention, the iridium, ruthenium or mixtures thereof exist in both elemental form and in oxide form. Typically, the iridium, ruthenium or mixtures thereof are from about 50 to about 90 mole percent elemental metal and from about 10 to about 50 mole percent oxide(s) of the iridium, ruthenium or mixtures thereof.

The thickness of the first resistive material layer (base material) may vary over a wide range. Preferably, the first material has a thickness of up to 1 mil. For use in embedded resistors, the first material is typically at least about 40 Å thick. In general, the thickness of the first material layer is from 40 to 100,000 Å (10 microns), preferably from 40 to 50,000 Å, and more preferably from 100 to 20,000 Å.

While the first resistive material layer may be self-supporting, it is typically too thin to be self-supporting and must be deposited on a substrate which is self-supporting. The resistive materials are typically disposed on a conductive material substrate, such as a metal foil. Other suitable conductive materials arc well known to those skilled in the art. Suitable metal foils include, but are not limited to, copper foil, nickel foil, silver foil, gold foil, platinum foil, and the like. Conductive metal foils suitable for use in the present invention may have a wide range of thicknesses. Typically, such conductive metal foils have nominal thicknesses ranging from 0.0002 to 0.02 inches. Metal foil thicknesses are often expressed in terms of weights. For example, suitable copper foils have weights of from 0.125 to 14 ounces per square foot, more preferably 0.25 to 6 ounces per square foot, and still more preferably from 0.5 to 5 ounces per square foot. Particularly suitable copper foils are those having weights of 3 to 5 ounces per square foot. Suitable conductive metal foils may be prepared using conventional electrodeposition techniques and are available from a variety of sources, such as Oak-Mitsui or Gould Electronics.

The conductive material substrates may further include a barrier layer. Such barrier layer may be on the first side of the conductive material, i.e. the side nearest the resistive material, the second side of the conductive layer or on both sides of the conductive layer. Barrier layers are well known to those skilled in the art. Suitable barrier layers include, but are not limited to, zinc, indium, tin, nickel, cobalt, chromium, brass, bronze and the like. Such barrier layers may be deposited electrolytically, electrolessly, by immersion plating, by sputtering, by chemical vapor deposition, combustion chemical vapor deposition, controlled atmosphere chemical vapor deposition, and the like. Preferably, such barrier layers are deposited electrolytically, electrolessly or by immersion plating. In one embodiment, when the conductive layer is a copper foil, it is preferred that a barrier layer is used.

Following the application of a protective barrier layer, a protective layer of chromium oxide may be chemically deposited on the barrier layer or the conductive material, Finally, a silane may be applied to the surface of the conductive material/barrier layer/optional chromium oxide layer in order to further improve adhesion. Suitable silanes are those disclosed in U.S. Patent No. 5,885,436 (Ameen et al.).

The first resistive materials may be deposited on the substrate by a variety of means, such as sol-gel deposition, sputtering, chemical vapor deposition, combustion chemical vapor deposition ("CCVD"), controlled atmosphere combustion chemical vapor deposition ("CACCVD"), spin coating, roller coating, silk screening, electroplating, electroless plating and the like. For example, nickel-phosphorus resistive materials may be deposited by electroplating. See, for example, International Patent Application No. WO 89/02212. In one embodiment, it is preferred that the first material is deposited by CCVD and/or CACCVD. The deposition of resistive materials by CCVD and/or CACCVD is well known to those skilled in the art. See, for example, U.S. Patent No. 6,208,234 (Hunt et al.) for a description of such processes and apparatuses used.

CCVD has the advantages of being able to deposit very thin, uniform layers which may serve as the dielectric layers of embedded capacitors and resistors. The material can be deposited to any desired thickness; however, for forming resistive material layers by CCVD, thicknesses seldom exceed 50,000 Å. (5 microns). Generally film thicknesses are in the 100 to 10,000 Å range, most generally in the 300 to 5000 Å range. Because the thinner the layer, the higher the resistance and the less material, e.g., platinum used, the ability to deposit very thin films is an advantageous feature of the CCVD process. The thinness of the coating also facilitates rapid etching in processes by which discrete resistors are formed.

For resistive material which is a mixture of a conductive metal and a minor amount of a dielectric material, the metal must be capable of being deposited as a zero valence metal from an oxygen-containing system if the resistive material is to be deposited by CCVD or CACCVD. The criteria for deposition in the zero valence state using a flame is that the metal must have a lower oxidation potential than the lower of the oxidation potential of carbon dioxide or water at the deposition temperature. (At room temperatures, water has a lower oxidation potential; at other temperatures carbon dioxide has a lower oxidation potential.) Zero valence metals which can be readily deposited by CCVD are those having oxidation potentials about equal to silver or below. Thus, silver, gold, platinum and iridium can be deposited by straight CCVD. Zero valence metals having somewhat higher oxidation potentials may be deposited by CACCVD which provides a more reducing atmosphere. Nickel, copper, indium, palladium, tin, iron, molybdenum, cobalt, and lead are best deposited by CACCVD. Herein, metals also include alloys that are mixtures of such zero-valence metals. Silicon, aluminum, chromium, titanium, cerium, zinc, zirconium, magnesium, bismuth, rare earth metals, and phosphorous each have relatively high oxidation potentials, such that if any of the metals mentioned above are codeposited with the appropriate precursors for the dielectric dopants, the metals will deposit in the zero valence state and the dopant will deposit as the oxide. Thus, even when no flame is used the dielectric needs to have a higher oxidation, phospidation, carbidation, nitrodation, or boridation potential, to form the desired two phases.

For more oxygen-reactive metals and alloys of metals, CACCVD may be the process of choice. Even if the metal can be deposited as a zero valence metal by straight CCVD, it may be desirable to provide a controlled atmosphere, i.e., CACCVD, if the substrate material on which it is to be deposited is subject to oxidation. For example, copper and nickel substrates are readily oxidized, and it may be desired to deposit onto these substrates by CACCVD.

Another type of resistive material which can be deposited as a thin layer on a substrate by CCVD is "conductive oxides". In particular, Bi₂Ru₂O₇ and SrRuO₃ are conductive oxides which may be deposited by CCVD. Although these materials are "conductive", their conductivity is relatively low when deposited in amorphous state; thus, a thin layer of such mixed oxides can be used to form discrete resistors. Like conductive metals, such "conductive oxides" may be doped with dielectric materials, such as metal or metalloid oxides, to increase their rcsistivity. Such mixed oxides may be deposited either as amorphous layers or as crystalline layers, amorphous layers tending to deposit at low deposition temperatures and crystalline layers tending to deposit at higher deposition temperatures. For use as resistors, amorphous layers are generally preferred, having higher resistivity than crystalline materials. Thus, while these materials are classified as "conductive oxides" in their normal crystalline state, the amorphous oxides, even in un-doped form, may produce good resistance. In some cases it may be desired to form low resistance, 1 to 100 Ω, resistors and a conduction-enhancing dopant, such as platinum, gold; silver, copper or iron, may be added, If doped with dielectric material, e.g., metal or metalloid oxides, to increase resistivity of the conducting oxides, or conduction-enhancing material to decrease resistivity of the conducting oxides, such homogeneously mixed dielectric or conduction-enhancing material is generally at levels between 0.1 wt % and 20 wt % of the resistive material, preferably at least 0.5 wt %.

There arc a variety of other "conducting materials" which though electrically conducting, have sufficient resistivity to form resistors in accordance with the present invention. Examples include yttrium barium copper oxides and La₁₋ₓSrₓCoO₃, 0 ≤ x ≤ 1, e.g., x = 0.5. Generally, any mixed oxide which has superconducting properties below a critical temperature can serve as electrically resistive material above such critical temperature. Deposition of such a variety of resistive materials is possible with proper selection of precursors selected from those described herein above.

To produce a metal/oxide resistive material film using a CCVD or CACCVD process, a precursor solution is provided which contains both the precursor for the metal and the precursor for the metal or metalloid oxide. For example, to produce platinum/silica films, the deposition solution contains a platinum precursor, such as platinum(II)-acetylacetonate or diphenyl-(1,5-cyclooctadiene) platinum (II) [Pt(COD)] and a silicon-containing precursor, such as tetraethoxysilane. Suitable precursors for iridium and ruthenium include, but are not limited to, tris (norbornadiene) iridium (III) acetyl acetonate ("IrNBD"), and bis (ethylcyclopentadienyl) ruthenium (II). The precursors are mixed generally according to the ratio of metal and enhancing material to decrease the resistivity of the material being deposited, an additional precursor is provided so as to produce minor amounts of the metal oxide or metalloid oxide, e.g., between 0.1 and 20 wt %, preferably at least about 0.5 wt %, of the deposited doped conducting metal oxide. The precursors typically are co-dissolved in a single solvent system, such as toluene or toluene/propane to a concentration (total of platinum, iridium, and/or ruthenium precursors) of from about 0.15 wt% to about 1.5 wt%. This solution is then typically passed through an atomizer to disperse the precursor solution into a fine aerosol and the aerosol is ignited in the presence of an oxidizer, particularly oxygen, to produce the platinum and iridium, ruthenium or mixture thereof zero valence metals(s) and oxide(s). See, e.g. U.S. Patent No. 6,208,234 B1 (Hunt et al.), herein incorporated by reference, for a more complete description of the CCVD process.

A wide variety of material arc suitable for use as the second resistive material to form the structures disposed on the first resistive material. The only requirement for such second resistive material is that it be different from the first material and possess a sheet resistivity that is lower than the sheet resistivity of the first material. Any of the resistive materials described above as being suitable as a first material is also suitable for use as a second material. Other suitable second resistive materials include zero valent metals such as gold, silver, copper, nickel, and the like as well as alloys thereof. Also suitable are materials useful in resistor formation in the semiconductor art, such as tungsten-cobalt-phosphide, tantalum-nitride and the like. The zero valent metals are particularly suitable for the second resistive material.

The second resistive material is typically disposed on the first resistive material The thickness of the second material may vary over a wide range, and is typically ≤1 mil. In. general, the thickness of the second material is ≤100,000 Å and is typically in the range of 10 to 100,000 Å. Preferably, such second resistive material has a thickness of 20 to 75,000 Å and more preferably 2 to 50,000 Å. Any of the deposition method described above for the first resistive material may also be used to deposit the second resistive material.

The structuring of the second resistive material may be achieved by an additive or a substractive process. For example, in an additive process, a resist, either positive or negative acting, such as a plating resist is applied to a layer of the first resistive material. The resist is imaged through a mask using an appropriate wavelength of actinic radiation. The mask may he of either a continuous or discontinuous structure pattern. The imaged resist is developed to provide the patterned resist. The second resistive material is then deposited using an appropriate technique and the remaining resist removed to provide a structured resistive material having a first or base resistive material and structures of a second resistive material disposed thereon.

In an alternate embodiment, the second resistive material may be directly applied in the form of structures, i.e. in lines, stripes, rows, etc., using screen printing, ink jet printing, and other procedures which deposit the second material in the desired configurations.

Alternatively, a subtractive process may be used. A layer of a second resistive material is disposed on the first resistive material. Unwanted portions of the second resistive material arc then removed, such as by laser ablation, chemical etching, and the like. Chemical etching may be accomplished by applying a layer of a resist to the second resistive material, imaging and developing the resist so as to remove the resist from the areas where it is desired to remove the second resistive material, and then etching away the second resistive material from those areas bared of resist. When such etching is performed, care needs to be taken to avoid etching away the first resistive material. If an etching process is to be used, the first and second resistive materials should be selected so as to provide a suitable difference in etch characteristics is achieved, i.e. such that the second material can be etched away in the presence of the first material without completely removing the first material.

In a further embodiment, it may be desired that when the second resistive material is a zero valent metal, that it be formed from a conductive substrate. By way of example, a first resistive material layer such as nickel-phosporus or platinum-iridium is deposited on a copper foil substrate. The copper foil may provide both the electrodes in the final resistor as well as the structures of lower resistivity material. The resistive material layer may be laminated to an organic dielectric material and a photoresist, such as a dry film resist, may be applied to the copper foil. The photoresist may then be imaged to form a pair of electrodes from the copper foil as well as to form continuous or discontinuous structures of copper, which remain after etching.

The structured resistive materials of the present invention typically contain a plurality of structures, which may be continuous or discontinuous. Continuous structures are structures which extend from one end of the first resistive material to its opposite end. Exemplary continuous structures are series of rows, lines, stripes, ribs and the like. Alternatively, the structures may be discontinuous, i.e. there is no continuous path of second material extending from one end of the resistive material to its opposite end. Broken lines and rows of circular, triangular, square, rectangular or elliptical, patches of second resistive materials are exemplary discontinuous structures. It is preferred that such discontinuous structures are staged or staggered such that there is no straight line path in one direction of first material extending from an end of the resistive material to its appropriate end. "Staggered" refers to rows of perforations wherein a row is offset as compared to other rows immediately adjacent to such row. In general, the structures arc spaced apart, meaning that the individual structures of the second resistive material do not touch each other. The width of the structures may vary considerably, with typical ranges being from 0.001 to 25 mils, preferably from 0.01 to 10 mils are more preferably from 0.05 to 5 mils. The distance between structures may also vary considerably, the only requirement being that the individual structures are not in electrical contact with each other. In general, the distance between structures may be from 0.01 to 25 mils, preferably from 0.05 to 20 mils, and more preferably from 0.1 to 10 mils. Discontinuous structures may have any suitable length that is less than the total distance from one end of the first resistive material layer to its opposite end in the direction parallel to the structures. When discontinuous structures are in a head-to-tail arrangement, the distance between the structures is such that they are not in electrical contact with each other. Suitable head-to-tail distances are from 0.01 to 50 mils, preferably 0.05 to 25 mils, more preferably 0.1 to 20 mils and still more preferably from 1 to 15 mils.

The present structured resistive materials contain areas of lower resistivity material (areas containing both first and second resistive materials) and areas of higher rcsistivity material (areas of first resistive material only). When the structures are continuous, such higher and lower areas of resistivity are typically alternating.

The present structured resistive materials are suitable for the manufacture of resistors, and in particular thin film, embeddable resistors useful in printed wiring board manufacture. Thin film resistors typically have a total thickness of structured resistive material of 4 µm or less, preferably 2 µm or less, more preferably 1 µm or less and even more preferably 0.5 µm or less.

Resistors typically include a pair of electrodes disposed at opposite ends of a resistive material. Such electrodes may be provided in a variety of ways, such as by formation directly on the resistive material or directly formed from an underlying conductive substrate. By way of example, areas of the resistive material to receive the electrode may be catalyzed so that electrodes are deposited, formed, or adhered only to those catalyzed areas. Alternatively, areas that are not to receive the electrode may be masked off, such as by a resist, and the electrode deposited formed or adhered to the unmasked areas.

Suitable electrodes may be formed by any conductive material such as a conductive polymer or a metal. Exemplary metals include, but are not limited to, copper, gold, silver, nickel, tin, platinum, lead, aluminum and mixtures and alloys thereof. "Mixtures" of such metals include non-alloyed metal mixtures and two or more layers of individual metals as in a multilayer electrode. An example of a multilayer electrode is copper having a layer of silver or a layer of nickel on the copper followed by a layer of gold. Such electrodes are typically formed by deposition of a conductive material. Suitable deposition methods include, but are not limited to, electroless plating, electrolytic plating, chemical vapor deposition, CCVD, CACCVD, screen printing, ink jet printing, roller coating and the like. When a conductive paste is used to form the electrode, it is suitably applied by screen printing, ink jet printing, roller coating and the like.

As described above, when the first resistive material is not self-supporting, it is typically applied to a substrate. Conductive substrates are particularly suitable for subsequent formation of resistors, particularly thin film resistors, as the conductive substrates can be used to form the pair of electrodes. This is generally accomplished using a photorcsist which is used to form a resist pattern over the layer of resistive material and using an appropriate etchant to remove the resistive material in areas not covered by the resist. For metal/oxide resistive material layers, the etchant chosen is an etchant for the metal component of the resistive material. Typically such etchants are acids or Lewis acids, e.g., FeCl₃ or CuCl₂ for copper. Nitric acid and other inorganic acids (e.g., sulfuric, hydrochloric, and phosphoric) may be used to etch nickel, a variety of other metals which may be deposited as well as conductive oxides.

Noble metals, by their non-reactive nature, are difficult to etch. Aqua regia is a suitable etchant for metals, particularly noble metals and is made from two well-know acids: 3 parts concentrated (12M) hydrochloric acid (HCl) and 1 part concentrated (16M) nitric acid HNO₃. Thus, the molar ratio of hydrochloric acid to nitric acid is 9:4, although slight variations from this ratio, i.e., 6:4 to 12:4 would be acceptable for etching purposes in accordance with the invention. Because of its corrosive nature and limited shelf life, aqua regia is not sold commercially, but must be prepared prior to use. To reduce its corrosiveness, the aqua regia may be diluted with water up to about a 3:1 ratio of water to aqua regia. On the other hand, the noble metals, such as platinum, are not etched by many of the materials suitable for etching copper, such as FeCl₃ or CuCl₂, thereby allowing for a variety of selective etching options in forming the present resistors. The speed of etching will depend upon several factors including the strength of the aqua regia and the temperature. Typically, aqua regia etching is conducted at a temperature of 55 to 60° C, although this may be varied depending upon the application.

By way of example, the circuitization process begins with a conductive foil, such as a copper foil, to which a layer of a first electrically resistive material has been deposited, such as by electroplating, CCVD or CACCVD. Structures of a second electrically resistive material are then formed on the first material by any of the methods described above to form a structured resistive material (or "resistive material"). Photoresist layers are then applied to both sides i.e. to the resistive material and to the conductive foil. The photoresist covering the resistive material layer is exposed to patterned actinic radiation while the photoresist covering the conductive foil is blanket-exposed to actinic radiation. The photoresists are then developed, giving a structure with a patterned photoresist layer covering the resistive material layer and the blanket-exposed photoresist layer protecting the conductive foil.

The resistive material layer is then selectively etched from areas where the photoresist had been removed. Subsequently, the remaining photoresist is stripped.

Following this, an organic laminate such as a polyimide or epoxy (either optionally glass-filled) is applied to the resistive material side. The laminate protects the now-patterned resistive material layer from further processing and subsequently supports patches of the resistive material layer when portions of the conductive foil is subsequently removed from the other side of the resistive material layer.

Next, a photoresist layer is applied to the conductive foil. This is imaged with patterned actinic radiation and developed. Following this, the conductive foil is etched with an etchant which selectively etches the conductive foil but which does not etch the resistive material layer. Stripping of the photoresist leaves the resistor which may subsequently be embedded in an organic dielectric material, such as a B-staged dielectric material including, but not limits to, epoxies, glass-filed, polyimides and the like.

As a variation of this process, it should be noted that if an etchant is used which selectively etches the electrically resistive material layer but does not etch or only partially etches the conductive foil, the use of a resist layer on the conductive foil is not necessary.

When referring herein to "etching", the term is used to denote not only the common usage in this art where a strong chemical dissolves or otherwise removes the material of one of the layers, e.g., nitric acid dissolves nickel, but also physical removal, such as laser removal and removal by lack of adhesion. In this regard, and in accordance with an aspect of this invention, it is found that resistive materials, such as doped nickel and doped platinum, deposited by CCVD or CACCVD are porous. The pores are believed to be small, typically of a diameter of a micron or less, preferably of a diameter of 50 nanometers or less (1000 nm = 1 µm). Nevertheless, this permits liquid etchants to diffuse through the electrically resistive material layer and, in a physical process, destroy the adhesion between the resistive material layer and the underlying layer. For example, if the conductive foil layer is copper and the resistive material layer is doped platinum, e.g., platinum/silica, or doped nickel, e.g., Ni/PO₄, cupric chloride could be used to remove exposed portions of the resistive material layer. The cupric chloride does not dissolve either platinum or nickel, but the porosity of the resistive material layer allows the cupric chloride to reach the underlying copper. A small portion of the copper dissolves and the exposed portions of the electrically resistive layer by physical ablation. This physical ablation occurs before the cupric chloride etches the underlying copper layer to any significant extent.

If copper is the conductive material layer, it is sometimes advantageous to use copper foil that has been oxidized, which is commercially available. An advantage of an oxidized copper foil is that a dilute hydrochloric acid ("HCl") solution, e.g., ½ %, dissolves copper oxide without dissolving zero valence copper. Thus, if the electrically resistive material layer is porous, such that the dilute HCl solution diffuses therethrough, HCl can be used for ablative etching. Dissolving the surface copper oxide destroys the adhesion between the copper foil and the electrically resistive material layer.

To minimize processing steps, the photoresists used can themselves be cmbeddable in materials, such as a permanent etch resist such as that available from Shipley Company, Marlborough, Massachusetts. Then both sides can be processed simultaneously if the etchant does not or only partially etches the conductor. In particular, only the resistor material side photoresist needs to be embeddable and the conductor side can be removed as a final processing step. Alternatively, the photoresists used on the conductor material side can be selected such that it is not removed with a specific stripper used to remove the resistor material side photoresist. Embedable photoresist may decrease tolerance losses due to particular undercutting of resistor material which under cut material will ablate once the photoresist is removed.

To be practically removable by an ablative technique, the resistive material layer must generally be sufficiently porous to an etchant which does not dissolve the electrically resistive material but sufficiently attacks the surface of the underlying material such as to result in loss of interfacial adhesion and ablation of the electrically conductive material within about 2 to 5 minutes. At the same time, such etchant must not substantially attack the underlying material, e.g., copper foil, during the etching period as such would cause excessive undercutting or loss of mechanical strength (i.e., reduce handleability).

The present invention provides a three-layer structure which comprises an insulating substrate, a layer of structured resistive material patches, e.g., platinum/silica formed in accordance with the invention by CCVD and having structures of a second material disposed thereon and conductive patches (i.e. electrodes), e.g., copper. Preferably, both the thin layer resistive material patches and the electrical connection conductive patches arc formed by photoimaging techniques.

The three-layer structure might be patterned in one of two two-step procedures by photoimaging technology. In one procedure, the conductive material layer would be covered with a resist, the resist patterned by photoimaging techniques, and, in the exposed areas of the resist, both the conductive material layer and the underlying resistive material layer be etched away, e.g., with aqua regia to give a structure of having a patterned structured resistive material patch (and a patterned conductive material patch). Next, a second photoresist would be applied, photoimaged, and developed. This time, only the exposed portions of the conductive material patch would be etched away by etchant which would selectively etch the conductive layer, but not the resistive material patch, i.c., FeCl₃ or CuCl₂ in the case of copper as the conductive material layer and platinum/silica as the electrically resistive material. In an alternate procedure, a patterned resist layer would be formed, exposed portions of the conductive material layer etched away, e.g., with FeCl₃, a further patterned resist layer formed, and then the exposed areas of the resistive material layer etched away with aqua regia so as to form the electrical contacts. By either procedure, discrete thin layer resistors are formed by conventional photoimaging techniques common to printed circuitry formation.

While the present resistors could be at the surface of a printed circuit board device, the resistors will, in most cases, be embedded within a multi-layer printed circuit board, for example where the resistor, which was formed on an organic dielectric substrate, such as polyimide or epoxy, is embedded within additional embedding insulating material layers, such as epoxy/fiberglass preprcg material.

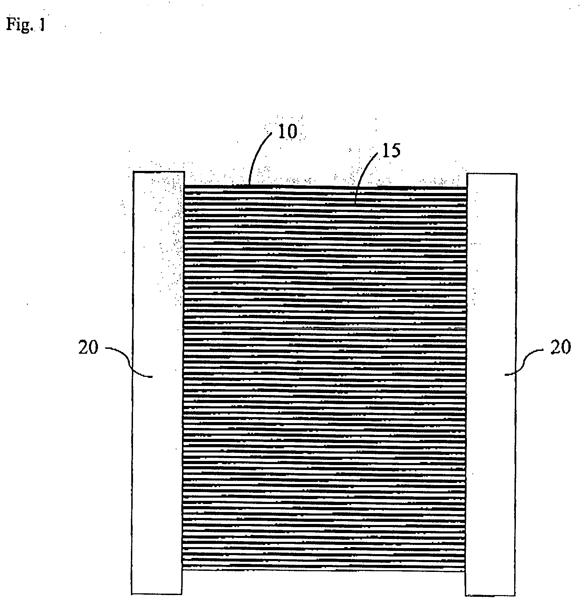

In one embodiment, the structuring on the resistive material is substantially parallel to the direction of resistivity, i.e. substantially orthogonal to the resistor electrodes. By "substantially parallel" it is meant that the stripes comprising the, structuring are nearly parallel to each other, i.e. such stripes do not intersect within the area defined by the resistive material. Fig. 1 illustrates a resistor having a first resistive material **10** having spaced apart ribs **15** (i.e. second, less resistive material) and a pair of electrodes **20.** The ribs **15** arc perpendicular (i.e. orthogonal) to the electrodes **20.** The path of the current is along the ribs **15.** Thus, the present invention provides a resistor having a resistive material and a pair of electrodes, each electrode being disposed at opposite ends of the resistive material, the resistive material having a plurality of structures disposed substantially orthogonal to the pair of electrodes.

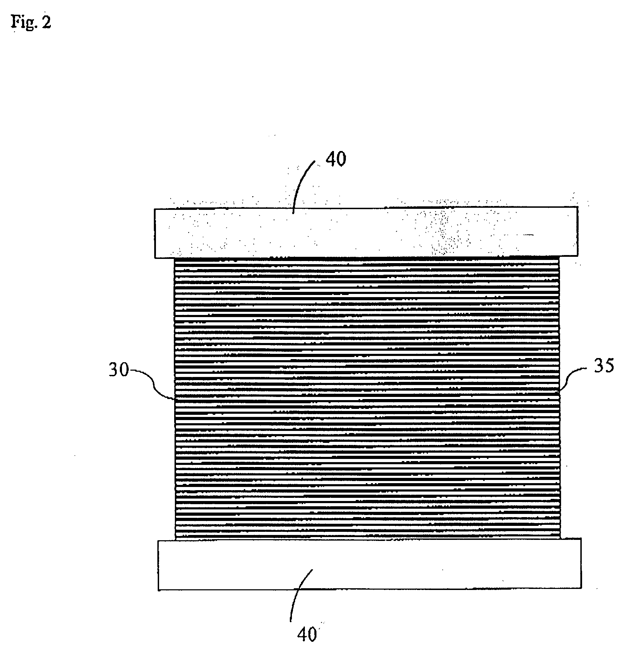

In a second embodiment, the structuring on the resistive material is substantially orthogonal to the direction of resistivity, i.e. substantially parallel to the resistor electrodes. Fig. 2 illustrates a resistor having a first resistive material **30** having spaced apart ribs **35** (i.e. second, less resistive material) and a pair of electrodes **40.** The ribs **35** arc parallel to the electrodes. The path of the current flows from one electrode to the other electrode, i.e. it transverses the areas of higher and lower (ribs **35**) resistivity. Thus, the present invention provides a resistor having a resistive material and a pair of electrodes, each electrode being disposed at opposite ends of the resistive material, the resistive material having a plurality of structures disposed substantially parallel to the pair of electrodes.

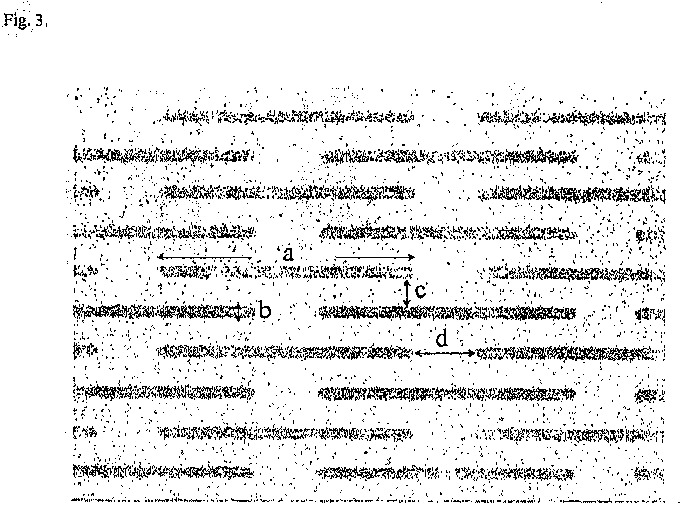

Fig. 3 illustrates a resistive material having discontinuous spaced apart ribs **45** on a first resistive material **50**. The ribs **45** have a length **a,** a width **b,** a spacing between adjacent rows of ribs **c,** and a head-to-tail spacing of **d** and possess a lower resistivity than first resistive material **50.** The length **a** is in the range of 20 to 40 mils, the width **b** is in the range of 1-4 mils, the spacing **c** is in the range of 3-5 mils, and the head-to-tail distance **d** is in the range of 8-12 mils,

In order to permit the free placement of resistors without regard to the location of the stripes on the sheet, the maximum width of the structures should be no more than one half of the minimum intended resistor dimension. There is no lower limit to the width of the structures other than the practical limit of being able to make a structure of that dimension. Such resistors must be designed to be an integral number of structure pairs (e.g. stripes) wide. For example, a resistor should be 20, 40, 60 mils, etc. wide for material that is made of alternating 10 mil wide stripes of a second resistive material and having 10 mil spacing between such stripes. It will be appreciated by those skilled in the art that the structures need not have a width equal to the spacing between the structures. The width of the structures may be greater than, less than or equal to the spacing between such structures.

As with standard embedded material, the final value of the resistor is determined by the aspect ratio of the resistor multiplied by the sheet resistivity of the material. Typically, the present resistors have a resistivity in a first direction of 1 to 100,000 Ω, preferably 10 to 100,000 Ω, more preferably 25 to 100,000 Ω, and still more preferably 100 to 100,000 Ω. The resistivity in a second direction that is substantially orthogonal to the first direction is generally greater than the resistivity measured in the first direction. Typically, the present resistor material has a resistivity in a first direction that is ≥ 2 times the resistivity measured in an orthogonal direction. Preferably, the resistivity in the first direction is ≥ 5 times the resistivity in the second direction, more preferably ≥ 10 times and still more preferably ≥ 20 times yet more preferably ≥ 50 times, and particularly ≥ 100 times. For example, the sheet resistivity could be 100 ohms per square in the x-axis and 10,000 ohms per square in the y-axis, yielding resistors of 100 ohms or 10,000 ohms, respectively, depending on the axis of orientation.

Resistors containing the present structured resistive materials may be used in the manufacture of electronic devices, and particularly as resistors embedded in a dielectric material, Thus, the present invention provides an electronic device including a resistor having a resistive material having a first resistivity in a first direction and a second resistivity in a second direction, wherein the second direction is substantially orthogonal to the first direction and wherein the first resistivity is greater than or equal to 2 times the second resistivity.

In particular, the present resistors are suitable for embedding in a dielectric material in the manufacture of printed wiring boards. Therefore, the present invention also provides an electronic device including a printed wiring board including a resistor having a resistive material having a first resistivity in a first direction and a second resistivity in a second direction, wherein the second direction is substantially orthogonal to the first direction and wherein the first resistivity is greater than or equal to 2 times the second resistivity. Also provided by the present invention is an electronic device including a resistor, the resistor including a pair of electrodes and a resistive material having a first resistive material layer and a plurality of structures disposed on the first resistive material layer, the structures including a second resistive material, wherein the resistive material has a first resistivity in a first direction and a second resistivity in a second direction, wherein the second direction is substantially orthogonal to the first direction.

The present invention provides a method of changing the resistivity of a resistive material layer comprising the step of structuring the resistive material in the direction of or orthogonal to the direction of resistivity. Such structuring is achieved by disposing a second resistive material on the resistive material layer. As described above, the second resistive material is disposed on the resistive material layer in the form of ribs, stripes, lines, rods, rows and the like.

The following examples are presented to illustrate further various aspects of the present invention, but arc not intended to limit the scope of the invention in any aspect.

### Example 1

An upper surface of a copper foil was coated with a first resistive material, such as an electroplated nickel-phosphorus layer. A commercially available nickel-phosphorus plating bath and standard plating conditions were used. A photoresist was applied to the first resistive material. The photoresist was imaged and developed to provide the desired continuous structures. A second resistive material (gold) having a lower resistivity than the first resistive material was then electroplated onto the areas bared of photoresist. A conventional gold plating bath was used under conventional plating conditions. The remainder of the photoresist was then removed.

### Example 2

The process of Example 1 is repeated using aspect ratios of lower resistivity material (i.e. Structures) of 1:1, 1:10 and 10:1, The resistance in both the X (parallel to the structures) and Y (orthogonal to the structures) directions is measured in each sample using conventional techniques. The data are shown in the following Table.

| Aspect Ratio | X-Axis(Ω) | Y-Axis(Ω) |
|---|---|---|
| 1:1 | 100 | 100,000 |
| 1:10 | 10 | 10,000 |
| 10:1 | 1000 | 1,000,000 |

## Claims

1. A resistor having a resistive material and a pair of electrodes disposed at opposite ends of the resistive material, the resistive material having a plurality of structures disposed substantially parallel to or substantially orthogonal to the pair of electrodes.

2. The resistor of claim 1 wherein the structures arc disposed parallel to the pair of electrodes.

3. The resistor of claim 1 wherein the structures are disposed perpendicular to the pair of electrodes.

4. The resistor of any one of claims 1 to 3 wherein the structures are selected from the group consisting of ribs, stripes, lines, rods, and rows.

5. The resistor of any one of claims 1 to 4 wherein the electrodes comprise a metal selected from the group consisting of copper, gold, silver, nickel, tin, platinum, lead, aluminum and mixtures and alloys thereof.

6. A printed wiring board comprising a resistor of any one of claims 1 to 5.

7. A resistive material having a first resistive material layer and a structures disposed on the first resistive material layer, the structures comprising a second resistive material, wherein the resistive material has a first resistivity in a first direction and a second resistivity in a second direction, wherein the second direction is substantially orthogonal to the first direction.

8. A printed wiring board comprising a resistor, the resistor comprising a pair of electrodes and a resistive material of claim 7.

9. An electronic device comprising the printed wiring board of any one of claims 6 or 8.

10. A method of changing the resistivity of a resistive material layer comprising the step of structuring the resistive material in the direction of or orthogonal to the direction of resistivity.
